# EUROPEAN PATENT SPECIFICATION

(11) **EP 0 393 103 B1**
(45) Date of publication and mention of the grant of the patent: **21.06.1995**
(21) Application number: 89900176.2
(22) Date of filing: 12.12.1988
(51) Int. Cl.: H01Q 21/00, G08B 13/24

(54) **ANTENNA STRUCTURE FOR PROVIDING A UNIFORM FIELD**
ANTENNENSTRUKTUR ZUR ERZEUGUNG EINES GLEICHFÖRMIGEN FELDES
STRUCTURE D'ANTENNES SERVANT A CREER UN CHAMP UNIFORME

(30) Priority: 10.12.1987 AU 5855/87
(43) Date of publication of application: 24.10.1990
(60) Divisional application: 94200836.8
(73) Proprietor: THE UNIVERSITY OF WESTERN AUSTRALIA, Nedlands, Western Australia 6009 (AU); MAGELLAN TECHNOLOGY PTY. LIMITED, Perth, W.A. 6000 (AU)
(72) Inventor: MURDOCH, Graham, Alexander, Munro, Perth, W.A. 6000 (AU)
(74) Representative: Newstead, Michael John
(86) International application number: AU8800476
(87) International publication number: WO8905530

(56) References cited:
- WO-A-83/02027
- WO-A-86/01924
- WO-A-87/04551
- AU-A- 2 631 784
- AU-B- 8 546 275
- FR-A- 2 076 468
- US-A- 3 689 885
- US-A- 3 832 530

## Description

The present invention relates to apparatus for and a method of powering a transponder.

The Applicants are aware of a number of transponder systems that provide three dimensional (or limited three dimensional) capabilities. These systems utilise a multiplicity of interrogator coils, each coil operating in one of three coordinate axes, to achieve three dimensional operation.

U.S. 3,689,885 and U.S. 3,859,624 disclose systems wherein, along each axis, the same coil is used to power the transponder as well as receive data from the transponder. Isolation of the powering and receiving functions is performed by either only powering one axis at any time and using the other two axes for receiving data or pulsing power transmission along an axis and, during the power transmission "OFF" period, receiving data back on the same axis. During the "OFF" periods an internal oscillator on the transponder generates the transponders clocking and data carrier signal. Should a transponder be orientated along only one axis then the first interrogation scheme as disclosed will not operate fully. No signal from the transponder couples into the other two coil axes and consequently no data is received. However, only if the transponder's transmitting antenna is not coplanar with its power receiving antenna would operation be guaranteed. While non-coplanar transponder coils are feasible the practical realization of them would be relatively expensive. The second interrogation scheme suffers from an inability to precisely control the clocking and carrier frequencies used by the transponder. The frequency of free running or crystal oscillators can vary with time. In addition, crystal oscillators are non-integratable and relatively expensive to implement.

U.S. 3,832,530 discloses a parcel or bag sorting system which utilises the principle of power absorbtion by the transponder for transmitting data. The interrogator antennas are structured as a cube designed to fit around a conveyor system. All three axes are simultaneously driven from one signal source. Three (3) dimensional operation is achieved by phase shifting the interrogation signal to two (2) of the coil axes. This phase change is made only once during the interrogation time. For an arrangement of coils powering two or three axes driven in phase, there will be a null direction for which the fields cancel.

As disclosed, changing the phase of any single coil shifts the direction of the null. Without accurately defining the null direction before and after shifting, it is possible for a transponder to be poorly coupled into the field during both interrogation cycles and fail to be identified.

U.S. 3,938,125 describes an anti-pilferage system wherein each of the three coordinate axes has a power transmitting antenna and a receiving antenna.

The powering signal is sequenced through each axis one at a time. The sequencing is done at a high speed (greater than 1 kilohertz). The transponder is designed to interact with two of the interrogation axes. The presence of a transponder is validated by a signal simultaneously being detected on two of the three axes. The system disclosed is not capable of transmitting data other than a simple presence detection.

The systems disclosed do not generate a uniform field distribution using their interrogation coils.

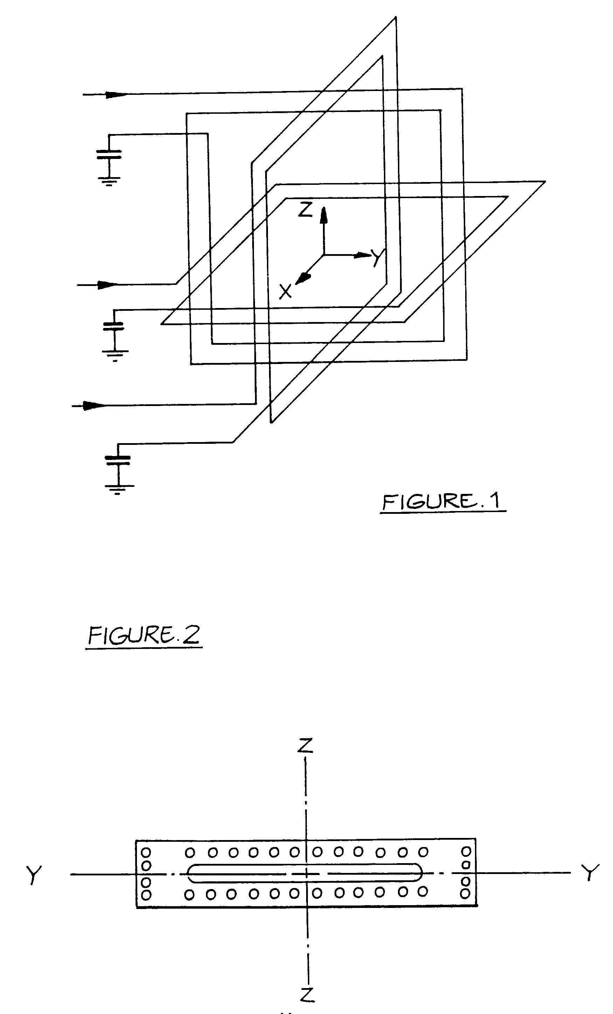

U.S. 3,859,624 details an elaborate voltage control circuitry which is considered inappropriate for a low cost integratable transponder system. Figures 1 and 2 show prior art coil arrangements.

AU-B1-85462/75 discloses apparatus having the pre-characterising features of claim 1.

According to the present invention from one aspect, there is provided apparatus for powering a transponder at a substantially uniform level of power substantially irrespective of the transponder's orientation and within a volume of space having width, height and depth directions, said apparatus comprising:
first, second and third powering coils each for radiating a respective powering field for reception by the transponder in one of the width, height and depth directions in said volume of space; and excitation means for applying current to each coil in a predetermined manner, characterized in that:
(a) said means for applying current excites sinusoidally any two of the coils at any one time by providing a single frequency sine signal to one of the coils and a single frequency cosine signal to another of the coils whilst the unexcited coil is left idle;
   the excitation is provided in a sequential and periodic manner in that the excitation is removed from the coil winding excited for the longest time and is applied to the previously unexcited coil; and
   each signal exciting the coils is unmodulated; or
(b) said means for applying current sinusoidally excites three of the coils, one coil with a first sine signal at a first frequency, the other coil with a substantially in-phase second sine signal at the first frequency and the third coil with a third, cosine signal at the first frequency; and
   the first and second sine signals are double-side band modulated at a low frequency with a phase-shifted angle of substantially 90°; or
(c) said means for applying current excites sinusoidally three of the coils, one coil with a single frequency sine signal, another coil with a single frequency cosine signal and the third coil with a signal marginally different in frequency from the single frequency sine and cosine signal; and
   each signal exciting the coils is unmodulated; or
(d) said means for applying current excites sinusoidally three of the coils, one coil with a single frequency first signal, another coil with a single frequency second signal and the third coil with a third signal, the signals differing from each other marginally in frequency; and
   each signal exciting coils is unmodulated.

One of the powering coils may be a solenoid coil.

Each coil may be formed of a pair of windings of predetermined configuration, the winding pair being positioned adjacent each other in opposite and facing configuration. In this case, each winding air may include a separation distance in the range from 0.1 to two times a length (d) of one of the winding sides. The separation distance may be substantially 0.8d. The predetermined configuration may be square or rectangular or elliptical or circular or C-shaped. The windings of each pair of windings may be arranged in substantially parallel planes. The apparatus may further comprise a mutual coupling element in the form of an inductance in series with at least one of said coils for substantially reducing mutual coupling between coils for different directional fields, each inductance being mutually coupled into the magnetic field of at least one other coil.

The apparatus may further comprise a receiving unit having a pickup coil and being positioned within the substantially uniform magnetic field. At least a portion of said pickup coil may be enclosed in a Faraday shield. Also, the apparatus may further comprise coil element(s), the or each element being provided in series with a respective receiving coil, the coil element being adapted to reduce the mutual coupling between the receiving coil and the series element and at least one of said coils providing said powering field. The apparatus may further comprise interference element(s), the or each element being provided in series with a respective coil, the interference element being a further coil adapted to obviate interference signals radiating from sources external to said structure.

According to the present invention from another aspect, there is provided a method of powering a transponder within a volume of space having width, height and depth directions, the method providing a substantially uniform level of power to the transponder substantially irrespective of the transponder's orientation and position within the volume of space, the method comprising providing current to each of first, second and third power coils in the width, height and depth directions respectively in the volume of space, the method being characterized by providing:
(a) a single frequency sine signal to one of the coils and a single frequency cosine signal to another of the coils, and leaving the third coil unexcited, the signal applied to a coil for the longest time being removed and applied to the previously unexcited coil, the signals being unmodulated and provided in a sequential and periodic manner; or
(b) applying signals all having the same frequency to the three coils, one coil with a first sine signal, another coil with a substantially in-phase second sine signal and the third coil with a cosine signal, the first and second sine signals being double-side band modulated at a low frequency with a phase shifted angle of substantially 90°; or
(c) applying to the coils unmodulated signals, one coil with a single frequency sine signal, another coil with a single frequency cosine signal, and the third coil with a signal marginally different in frequency from the sine and cosine signals; or
(d) applying to the coils unmodulated signals, one coil with a single frequency first signal, another coil with a single frequency second signal, and the third coil with a third signal, the signals differing from each other marginally in frequency.

The present invention will now be described, by way of example, with reference to the accompanying drawings, in which:

Figures 1 and 2 show a prior art arrangement, as hereinbefore described.

Figures 3 and 4 show a coil spacing to generate a substantially constant power field in one axis.

Figure 5 depicts field strength measurements of the arrangements of Figures 3 and 4.

Figures 6a, 6b, 7a and 7b show further field radiator arrangements. Note Figure 7b shows both exploded and 3D formed views.

Figure 8 shows an antenna loop.

Figure 9 shows a parallel connected antenna loop.

Figure 10 shows a series connected antenna loop.

Figures 11 and 12 show two series and two parallel, respectively, coil configurations incorporating a variable inductance.

Figures 13 and 14 show a phase feedback loop.

Figure 15 shows a preferred embodiment of the variable inductance.

Figure 16 shows wave forms associated with a variable inductance.

Figure 17 shows one embodiment of a resonant frequency control circuit.

Figure 18 shows another embodiment of a variable inductance.

Figures 19, 20, 21A and 21B show an alternative variable capacitor and its respective waveforms.

Figure 22 shows a system for cancelling mutual coupling between powering coil axes.

Figure 23 shows a leakage field reduction scheme.

Figure 24 shows a method of reducing the series voltage across the powering coils or coil pairs.

Figures 25, 26A and 26B show a method of reducing the coupling to an antenna.

Figure 27 shows a method of reducing interference to an antenna.

Figure 28 shows the preferred coil axis excitation scheme.

Figure 29 shows one method of generating a constant magnitude powering field, wherein double side band modulation is on two axes, continuous wave on the third axis.

Figure 30 shows another method of generating a constant magnitude powering field, wherein sine and cosine is on two axis, offset frequency continuous wave on third axis.

Figure 31 shows yet another method of generating a constant magnitude powering field, wherein a marginally different frequency is on each of three axes.

Figures 32A and 32B show two preferred transponder circuits for detecting modulation of the powering field.

Figures 33A and 33B show two preferred circuits for generating FSK or PSK modulation of the powering field.

Figures 34A, 34B and 34C show three preferred circuits for modulating the amplitude of the powering field for Am, PM or any other amplitude modulation scheme.

The present invention is advantageously adapted for passive transponder powering and communication systems and methods, but the disclosure herein should not be construed as limited to such a transponder system application. The application of the present invention, however, provides an explanatory example. Accordingly, further description of the invention will be made in a non-limiting way with reference to such an application. The present invention allows for powering and/or communication within a space irradiated by a substantially constant magnitude electromagnetic field.

The simultaneous action of power transfer and data or command transmission by the same magnetic field may allow the remote control of electromechanical devices and electronic circuits and the remote programming of E² PROM or conventional CMOS memory with battery backup in a known manner.

The transponder utilises a coil to simultaneously pickup the powering magnetic field and transmit the transponders identifying signal.

The voltage picked up by the transponder coil is dependent upon the cosine of the angle between the transponder coil axis and the direction of the magnetic field.

For those applications where the orientation of the transponder will be random such as baggage and livestock identification, special driver coils and coil drivers are necessary.

Ideally the power transferred to the transponder coil should be independent of transponder orientation and constant over a volume of space so that rapidly moving transponders can be satisfactorily identified.

Three dimensional powering and communication structures should be used where transponder orientation may be random.

For situations where the transponder coil orientation is always in the same plane, only a structure having at least one coil may be necessary.

A method and apparatus for transmitting data and/or power using an inductive powering field may be as follows :

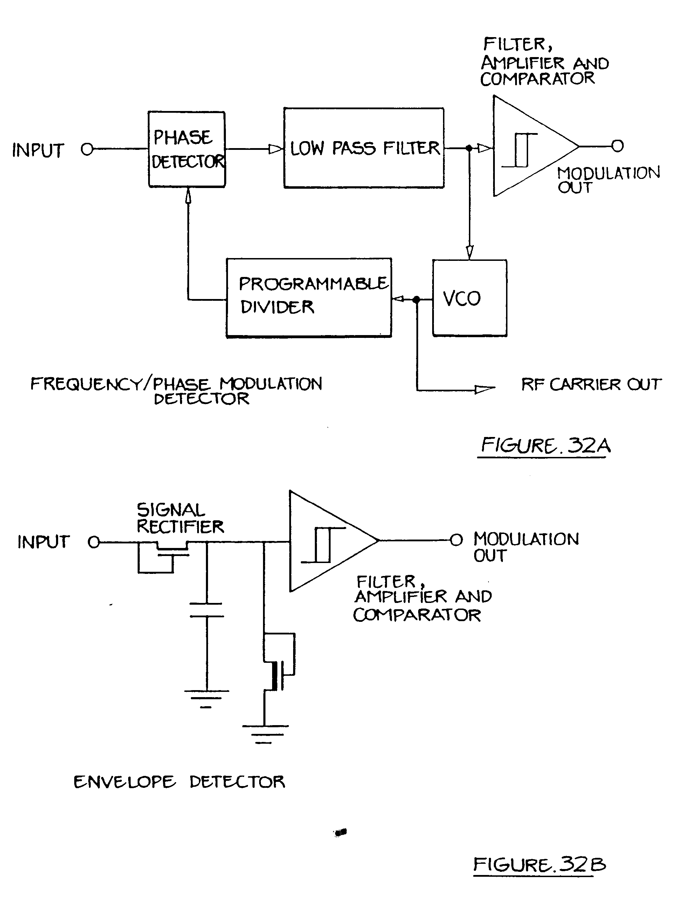

Generally, data or command instructions can be transmitted by modulating an oscillating magnetic field. The oscillating field may be also used to transmit power to an inductively coupled tuned distant unit. The distant unit might be a transponder, actuator or any other unit. A modulation detector on or in the transponder may detect the modulation and so present it to appropriate decoding circuitry (Figures 32A and 32B).

The transponder may utilise the frequency of the powering field as a frequency reference for the generation of its internal clocking signals and data carrier signal(s). Utilising the powering field as a frequency reference at all times allows the interrogator to use coherent detection of the transponder data signal. The interrogator's coherent detection circuitry being similarly locked to the powering field frequency reference.

For an arbitrarily modulated oscillating magnetic field, the data rate may be limited by the bandwidth of the transponder. This bandwidth should be sufficiently large to allow a data rate of required number of bits per second.

Preferably, the magnetic field may be phase or frequency modulated because these do not appreciably affect the magnitude or intensity of the power transmitted from the transmitter to the receiving unit.

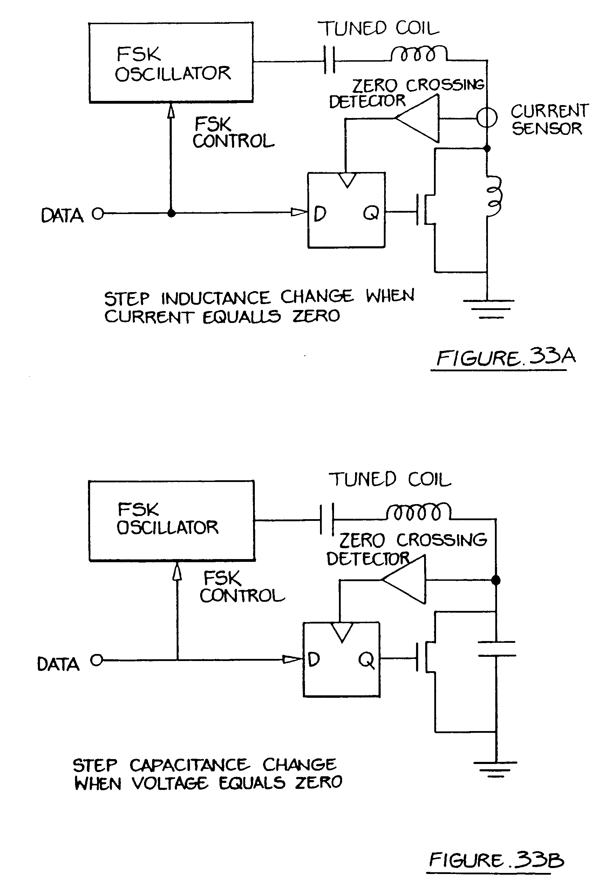

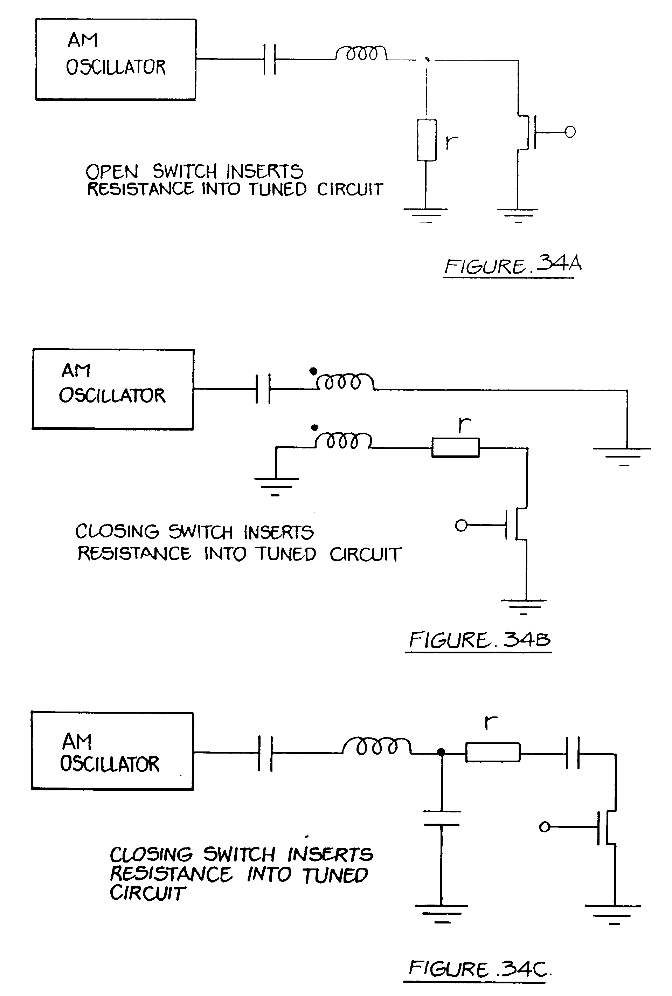

Frequency, phase, amplitude or pulse width or position modulation or any combination of these can be used to modulate the magnetic powering field (Figures 33A, 33B, 34A, 34B and 34C).

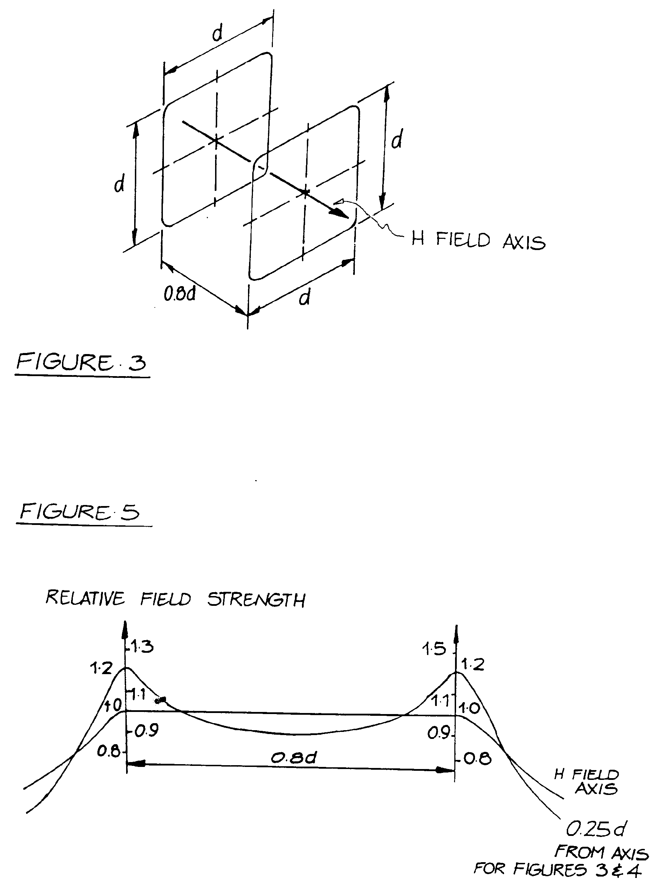

To provide a substantially uniform powering field three sets of coils may be orientated along the X, Y and Z axes, respectively. The phase and frequency used to drive these coils can be carefully controlled to generate a substantially constant magnitude powering field. Also, to provide a uniform field over a volume of space, the magnetic field along each axis is generated by one, two or more coils as are necessary. Preferably, coil pairs are used. The coil size, shape and spacing ratios represent a substantial departure from the standard helmholtz coil arrangement i.e. the two coils are facing each other but for coils that are substantially square in shape, they are spaced at a distance in the range 1.2 to 0.5 and preferably substantially 0.8 times the length of an adjacent edge of one of the coils. This new spacing provides an adequate field along the coil axis and a substantially constant field over a large fraction of the volume enclosed by the coils. Figure 3 shows such an arrangement.

A uniformly distributed field over the largest possible interrogation volume increases identification reliability by providing constant coupling efficiency over that volume. Constant coupling ensures both uniform data transmission from and powering to of the transponder with commensurate reductions in voltage control circuitry on the transponder.

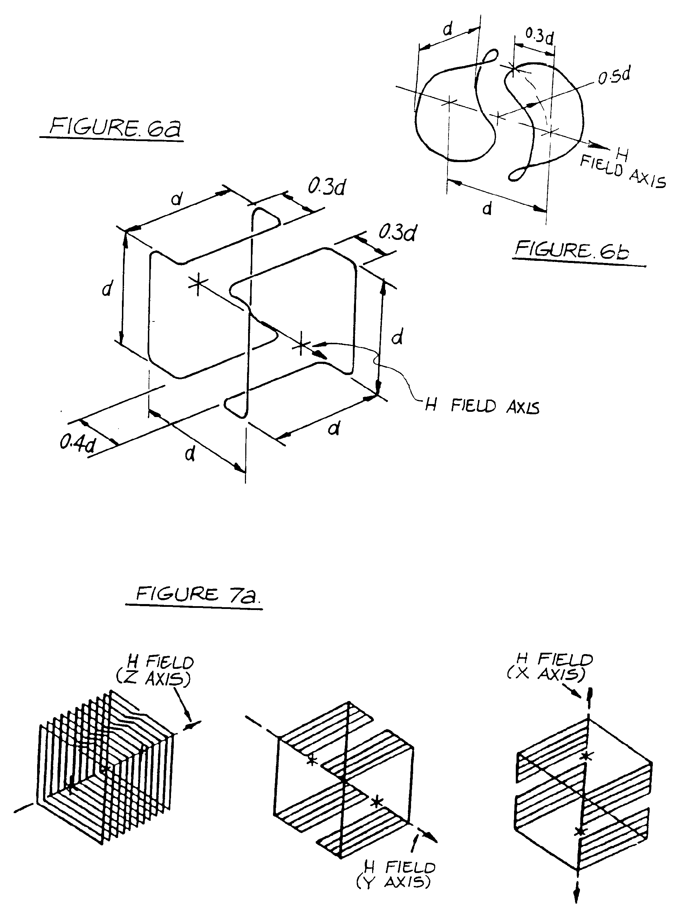

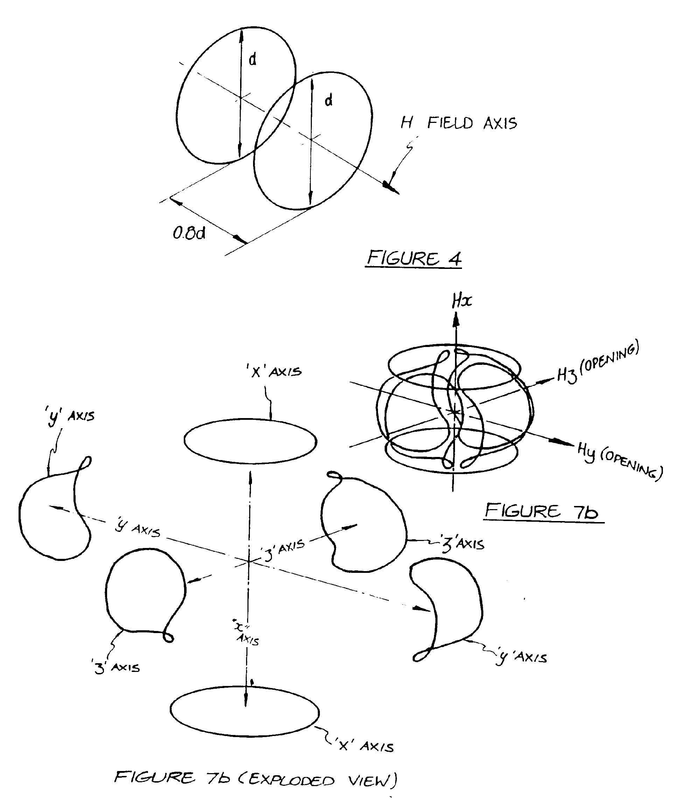

Figures 7a and 7b show three sets of coils (in X, Y and Z axis) arranged to form a box or ball like structure, through the centre of which a transponder may pass. Inside the structure of the present invention, the power transferred to the transponder is substantially constant in magnitude over a well defined volume within the enclosed space.

It should be noted that for those applications where the orientation of the tag is fixed or known, elaborate powering schemes may not be necessary. Only one coil or coil pair may be required to provide a powering field operatively corresponding in orientation to the fixed or known orientation.

It can be shown that for single frequency sinusoidal magnetic excitation of the three coordinate axes, there will always be a null direction i.e. a direction in which the field will be zero.

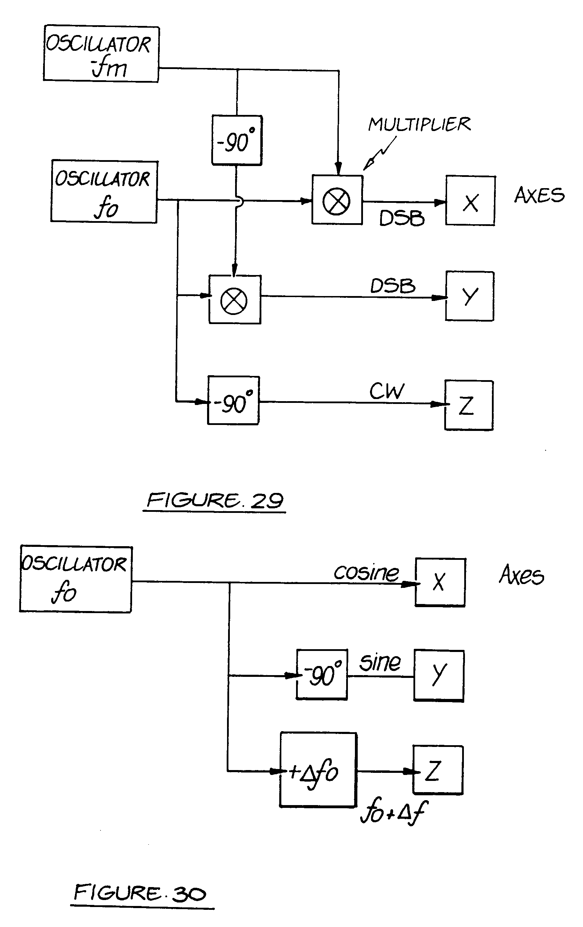

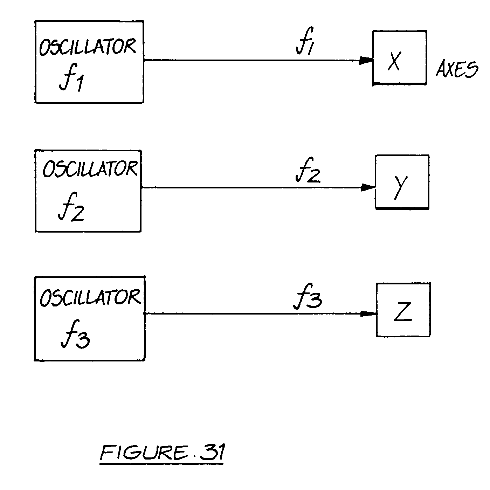

There are several methods by which the constant magnitude powering field may be generated; only some of which are detailed below as preferred methods (a) to (d) :
(a) Two of the coils or coil pairs can be driven at a frequency with a phase angle of substantially 0°. The third coil or coil pair can be driven at the same frequency but at a phase angle of substantially 90°. The amplitude of the first two coils is then double side band (DSB) modulated at a low frequency with a phase angle of substantially 90° between the two amplitudes used to modulate the coils. This combination of signals produces a circularly polarized magnetic field which rotates about the axis of the third coil. By adjusting the relative magnitudes of the signals along each axis to compensate for the frequency characteristics of the transponder pickup coil, constant power independent of orientation will be absorbed by the transponder (Figure 29).
(b) Two of the coils or coil pairs can be run at the same frequency phased substantially 90° apart. This provides a circularly polarized field in the axis plane of the two coils. The third coil or coil pair can be run at a slightly different frequency. The circularly polarized field can be tipped on its side and proceed to precess about the third coil at the difference frequency between the two driving frequencies. The power picked up by a transponder is substantially uniform without regard to orientation (Figure 30).
(c) The three coils or coil pairs can be run at three slightly different frequencies. Provided that the magnitude of each axis field is adjusted to compensate for the frequency characteristics of the transponder, then the power picked up by the transponder will be substantially independent of orientation (Figure 31).
(d) The coils or coil pairs can be sequentially or cyclically activated such that at least one coil or coil pair is active at any point in time. The cycle time must be short enough to ensure that a transponder could not pass through the driving coils without being activated. Rapid cycling of coil activation should enable the power picked up by a through passing transponder to be independent of its orientation.

Options (a) to (d) represent only some preferred choices for substantially uniform magnitude powering field.

Another method and apparatus for generating a uniform magnetic field over a well defined volume suitable for two or three dimensional inductive powering of a randomly orientated transponder is also herein described. Note, all numerical values herein described are approximate and are with reference to preferred embodiments only.

The coil structures herein described have been designed to produce, in magnitude, a substantially uniform magnetic field over a well defined volume. The substantially uniform field strength enables a uniform voltage to be induced to a transponder or other unit thereby reducing the demand upon any voltage regulation circuitry that may be required to be carried in the transponder.

The coil structure shown in Figure 3 consists of a pair of coils facing each other. The gap between the coils can be chosen to produce the necessary uniform field strength. It has been found that for square and circular coils, a coil spacing in the range 1.2 to 0.5 and preferably substantially 0.8 times the length of one side (d) or the diameter (d) of a coil enables a substantially constant field magnitude distribution to be obtained along the H field axis between the spaced coils. The field strength at a point up to substantially 0.25d perpendicular or laterally to that axis will provide a field intensity as shown in Figure 5.

For two or three dimensional inductive powering, a pair of square or circular coils spaced at 0.8d may be used to generate the magnetic field along each desired orthogonal axis. When all three coil pairs are combined to provide a cubic structure, there will be therein provided a small region or point of constant field magnitude. A cube or sphere within which field intensity varies only marginally surrounds this constant point. The cube has a side length of 0.5d (i.e. 2 x 0.25d) and the sphere has a radius of 0.5d. Within this cube or sphere, the power will vary in magnitude substantially 20% greater nearest the powering coils and substantially 10% less in the middle of each side relative to the constant point. Thus, the powering structure provides a space within which an acceptable powering field is provided.

A more complicated coil pair shown in Figures 6a and 6b may also be used to further improve the uniform distribution of the magnetic field over a larger volume of a cubic or spheric structure. The preferred spacing of the field radiator coils is 0.4 d, as shown in Figures 6A and 6B. Current circulating in this coil pair may generate a field along the H axis substantially as indicated. This type of coil structure comprises coils substantially "C" shaped in side view. A cubic or spheric structure may be formed from C shaped coils wherein a substantially uniform magnitude field is provided in a cube or sphere, the cube having sides of 0.7d in length (compared with substantially 0.5d cube for the flat coil structure of Figure 3), and the sphere having a radius of 0.35 d (compared with substantially 0.25 d for the flat coil structure of Figure 4). A combination of flat and C shaped coils can provide uniformity within a cube ranging in size from 0.7d to 0.5d or within a sphere ranging in radius from 0.35 d to 0.25 d. Within the cube or sphere, the field will vary in intensity by + 20% to - 10%.

Expanding the coil turns so that a solenoid like structure is achieved may provide a more even field distribution. Figure 7 shows three coil structures which when combined together, provide a substantially uniform field over greater than substantially 0.7d of the coil's cross section. It should be noted that the structure of Figure 7, when combined, will provide powering in three dimensions as hereinbefore described, but will also have two sides of the 3D cube open to allow entry and exit passages through which external unit(s) can proceed and so be influenced by the 3D field irrespective of the unit(s) orientation. The greater the number of coil windings in each orthogonal axis, the larger the area over which a constant field is produced. The magnetic field (H) may be generated in all three axes as shown.

The most preferred two dimensional power field is generated by two orthogonal coil pairs, the coils being excited by a sine and cosine wave signal, respectively. This produces a circularly polarized magnetic field in the plane of the two coil pairs. Power transfer to a transponder contained between the coils is substantially uniform and independent of the axial position within the two planes.

For three dimensional powering, three orthogonal coil pairs are required. Accurate control of the frequency and phase exciting each coil pair is necessary for generating a constant magnitude powering field.

A preferred method includes exciting two coil pairs at the same time; the third coil pair remains idle. The two 'on' coil pairs are excited by a sine and cosine wave current, respectively, as for the two dimensional case. Reception of response signals from a field excited transponder is performed by antenna(s) in the same axis as the two "on" coil pairs irradiating the powering field.

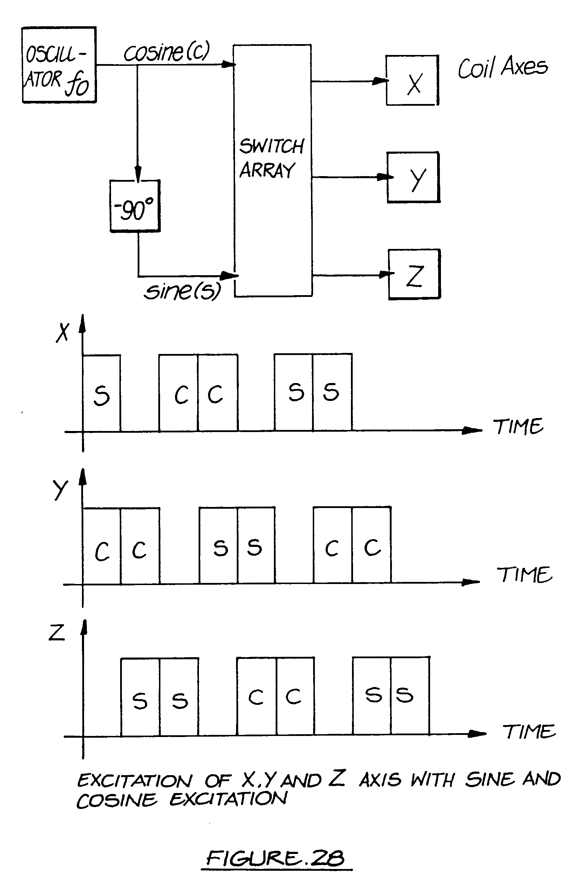

This may produce a circularly polarized magnetic field in the plane of the two excited coil pairs. The polarized magnetic plane may then be sequenced between the three possible polarization planes. This sequencing may be performed in several ways. Preferably, the first and second coil pairs can be excited with a sine and cosine current, respectively. The sine current excitation to the first coil pair may then be turned off and redirected to the third coil pair. Subsequently, the cosine current excitation of the second coil pair can be removed and directed to the first coil pair. This process of removing excitation from the longest running coil pair and directing it to the idle coil pair can be repreated in a continuous or sequential manner (Figure 28). The rate of switching should be chosen to allow sufficient time for a randomly orientated transponder to identify itself. It should be noted that, at each sequencing interval, the phase of the excitation directed to the idle coil pair may be reversed by 180° without impairing the uniform transfer of power. Using this method of coil pair phasing and switching, the average power transferred to a transponder pickup coil may be substantially near uniform and substantially independent of the pickup coil's orientation within the powering field.

Even though each coil pair is orthogonally orientated with respect to the other coil pairs, there will be some mutual coupling between coil pairs. This mutual coupling can be substantially reduced by winding a small compensation coil in series with the coil pairs on each axis. The compensation coil is coupled to the field of another axis so as to substantially negate or reduce the mutual coupling already existing between the two respective coil axes. It is noteworthy that mutual coupling between air cored coils exhibits reciprocity. Hence, cancelling the mutual coupling from axis X to axis Y also cancels it from axis Y to axis X.

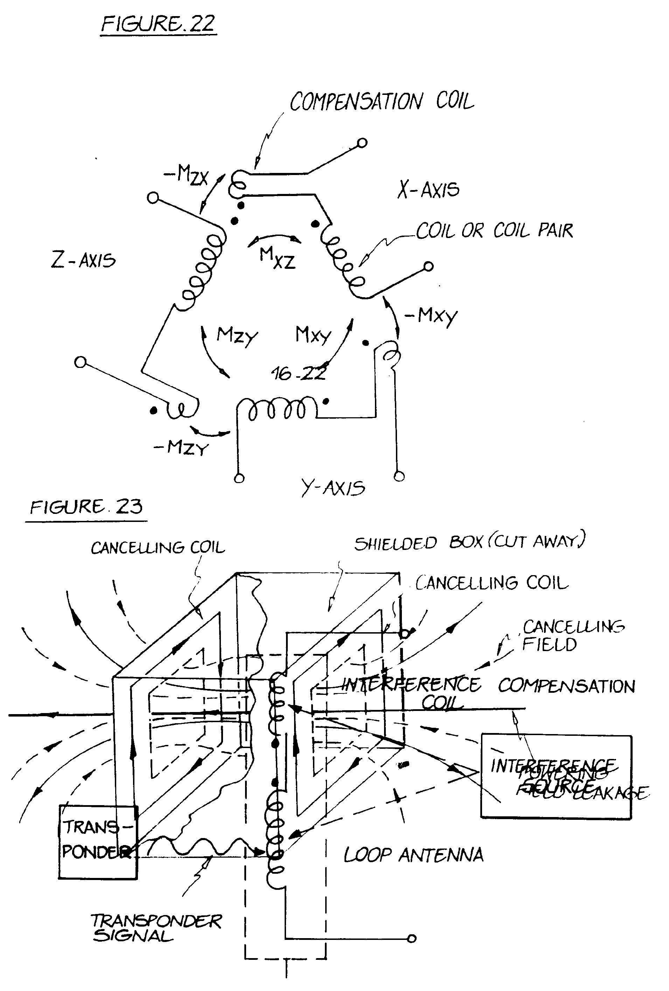

Figure 22 diagrammatically shows a system for reducing the mutual coupling between all three axes. The degree of coupling to each compensation coil is varied to null out the mutual coupling.

The whole powering coil structure may be housed inside a metallic shielded housing. The shielding reduces both the radiation of the magnetic powering field from the powering coils and the reception of external interference by the transponder signal receivers. Ideally, the shielding should be made of a high conductivity metal such as copper or aluminium with a thickness of 4 to 5 skin depths at the powering frequency, preferably about 1 mm.

To reduce powering field leakage from the entrance and exit ports of the shielded housing, field cancelling coils coaxial with the point can be used. Current is directed through these coils so that the generated field opposes the axial leakage field (Figure 23).

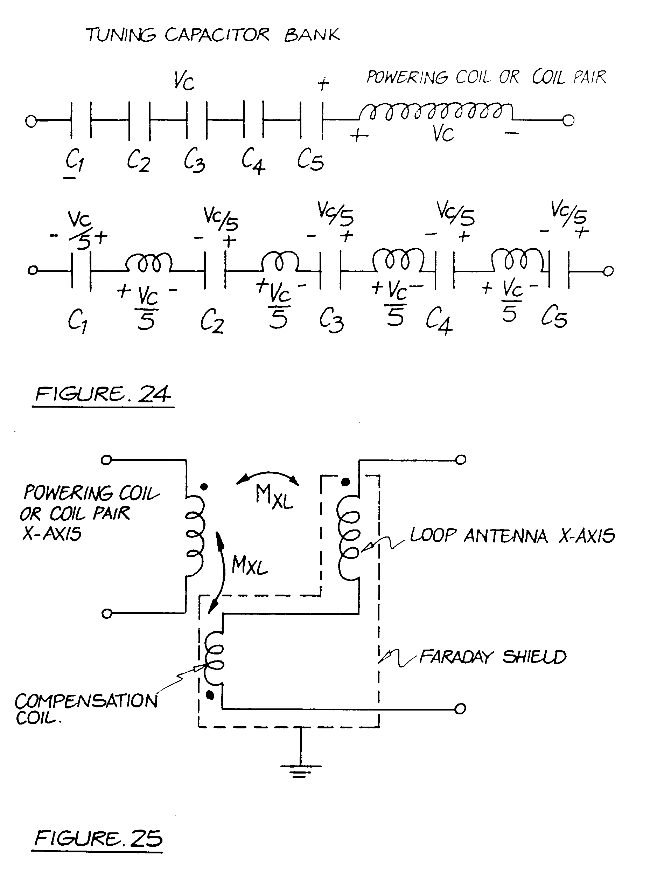

Capacitive radiation from the powering coils can be reduced by minimising the voltage across the turns of the powering coils. This may be done by distributing the series tuning capacitor along the coil, i.e. inserting parts of the series tuning capacity in series with the powering coil(s) at points preferably evenly distributed along the coil length (Figure 24).

A method and apparatus for receiving inductive RF, code or coded signal(s) transmitted by any number of remote unit(s) or transponder(s) will now be described. The receiving may be carried out simultaneously by antennas within the same structure which transmits magnetic power.

Antenna loop(s) may be adaptively tuned to the carrier frequency and receive the transponder signal. The loop(s) may be shielded with faraday shields to alleviate stray capacitive coupling from altering the tuned frequency of the loops. Each loop may consist of one or more coils of conductor. The loops, if formed in a structure separate but enclosed by the powering coils, may be arranged in a manner similar to that of the powering coils, thereby receiving the transmitted signal along each of the orthogonal X, Y or Z axes. A pair of loops may be used for each axis and, in a preferred form, may be placed one on each side of the uniform powering region. The loop pairs may be placed as closely as possible to the region where inductive powering occurs as this provides a greater coupling efficiency between the transponder and the antenna loops. Any variation in signal transmission associated with the position of the transponder may be readily corrected by electronic automatic gain control circuitry in a known manner.

It is preferable that the voltage induced in the antenna loops by the powering field is kept as small as possible to minimise any influence upon the sensitive receiving circuitry. By extending each antenna to form a compensation coil, against the powering coil pair in the same axis as the antenna, this induced voltage can be substantially nulled out (Figure 25).

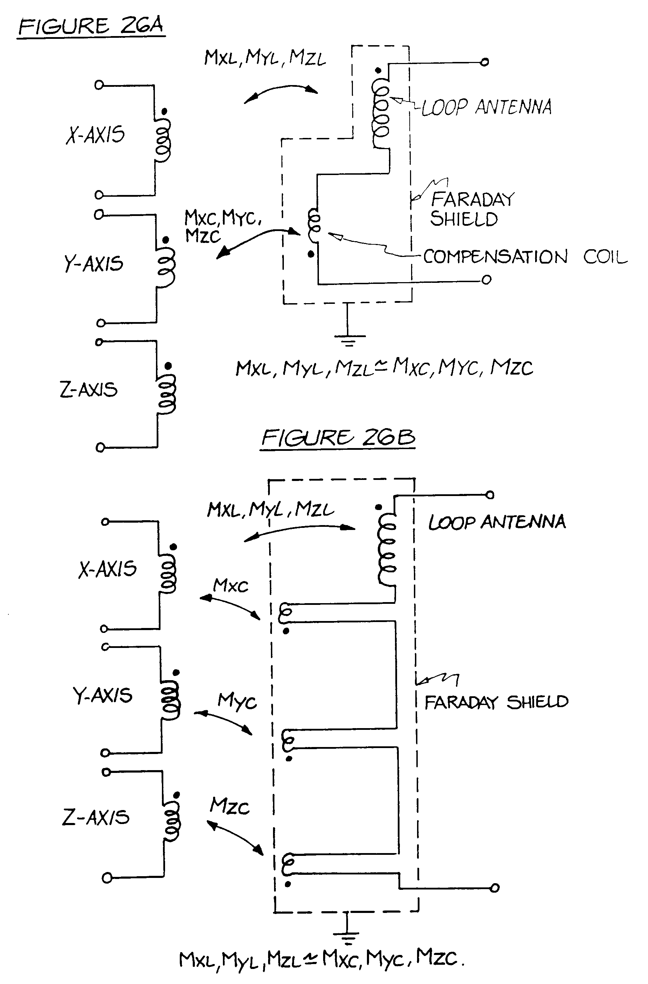

By positioning each compensation coil to pickup signals from the other coil axes or by adding further compensation coils along the other axes, any pickup voltage from the other axes can be substantially nulled out (Figures 26A and 26B).

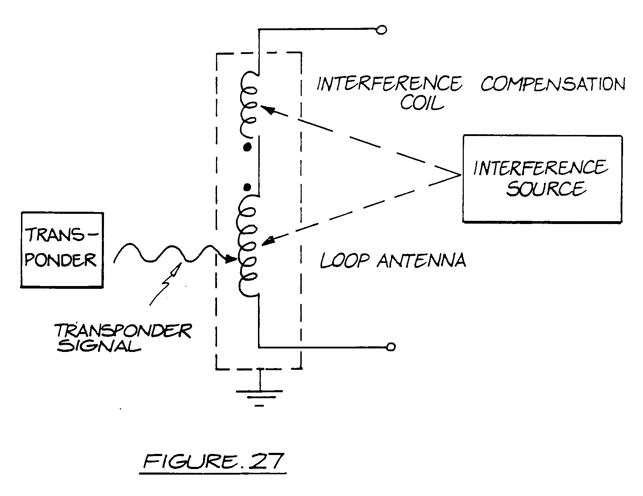

Interference from external sources can be substantially reduced or nulled out by an externally mounted compensation coil designed to receive interfering signals and substract them from the signal picked up by the antenna loop(s) (Figure 27).

Enclosing all compensation coils in Faraday shields substantially prevents capacitive coupling from the powering coils.

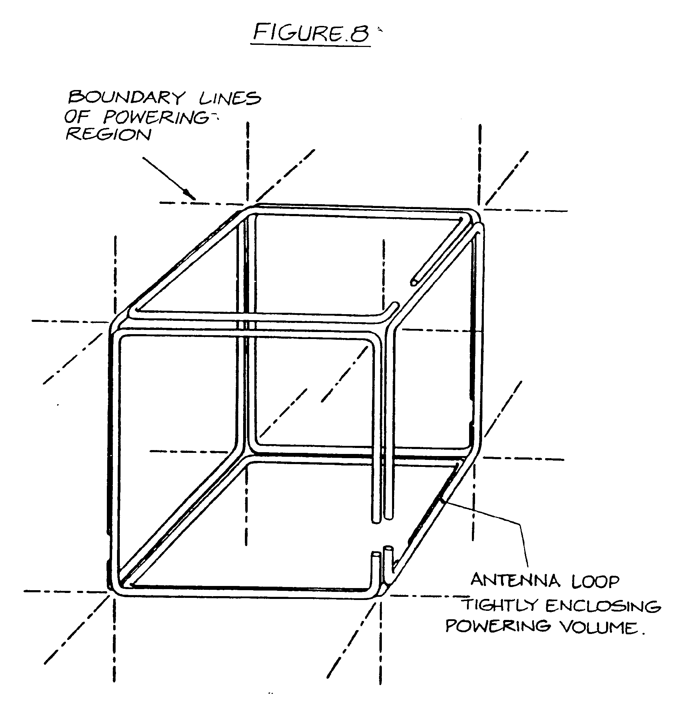

Figure 8 shows how the antenna loops may be preferably structured around the inductive powering region.

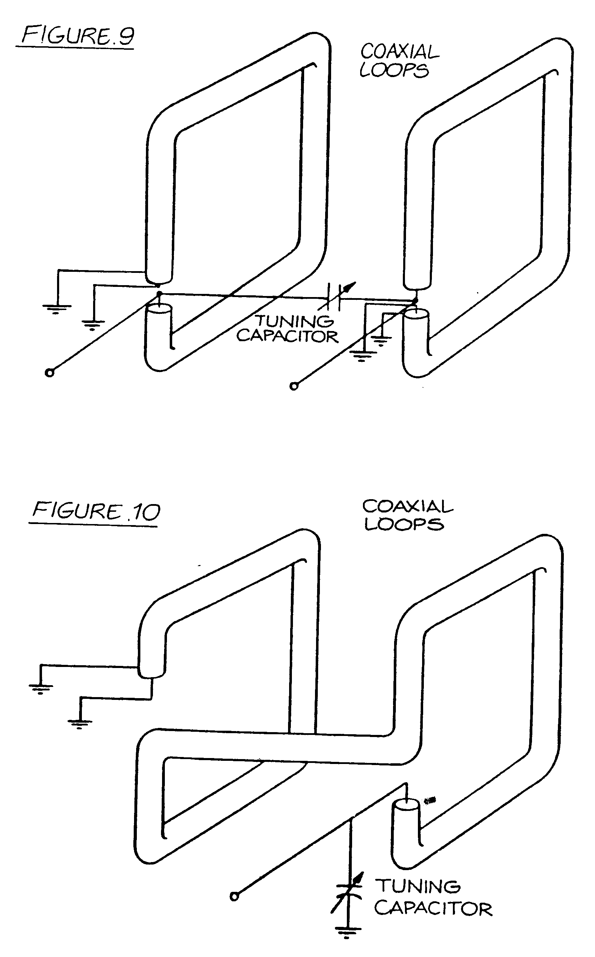

Figure 9 shows a preferred pair of parallel connected antenna loops. Alternatively, the loop pairs may be connected in series and the single ended output voltage used as the received signal. A tuning capacitor may also be used to tune the series connected loops.

Figure 10 shows a preferred series connected antenna loop.

A method and apparatus for control of a structure for two or three dimensional inductive powering of a remote device by controlling the magnetic field's frequency and phase are now to be described.

The magnetic field can be generated by currents circulating in specially structured coil pairs, as detailed above, or the field may be generated in any other conventional way. To improve the current(s) within the coil(s), each coil pair is tuned to resonance or near resonance at an operating frequency. Accurate tuning of the coil(s) provides for more efficient operation. Control of the resonate frequency may be provided by using a variable inductor (saturable reactor) or variable capacitor in series or parallel with each coil or coil pair.

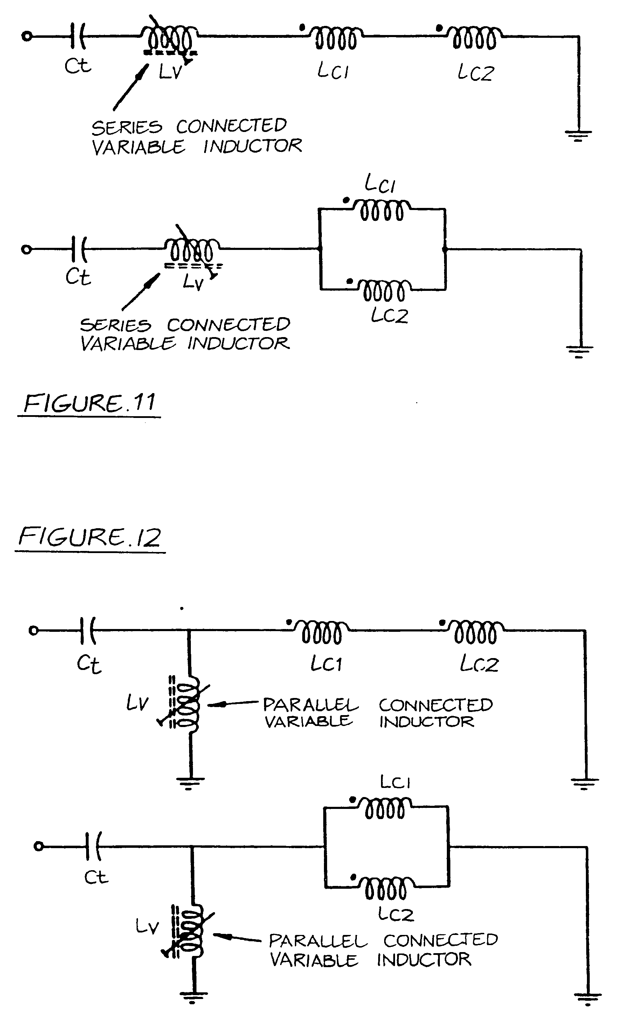

Inductance is varied by a dc current. Phase sensing circuitry may monitor the current within the coil pairs and produce a dc current for controlling the variable inductor. Control of the phase of the currents circulating in the coils may be achieved by the phase means. A signal source of required frequency and phase drives each coil pair. The variable inductor enables each coil to be tuned to resonate at substantially the same frequency. The variable inductor may also provide compensation for fluctuations in coil tuning caused by time, temperature, object proximity, etc. Figure 11 shows two series configurations and Figure 12 shows two parallel configurations incorporating a variable inductance for controlling resonant frequency.

With reference to Figures 11 and 12, Lc1 and Lc2 are the two coils used to generate the magnetic field along an axis, Ct is the tuning capacitance and Lv is the variable inductance. It is understood that these configurations may also apply if only one or more than two coils are used.

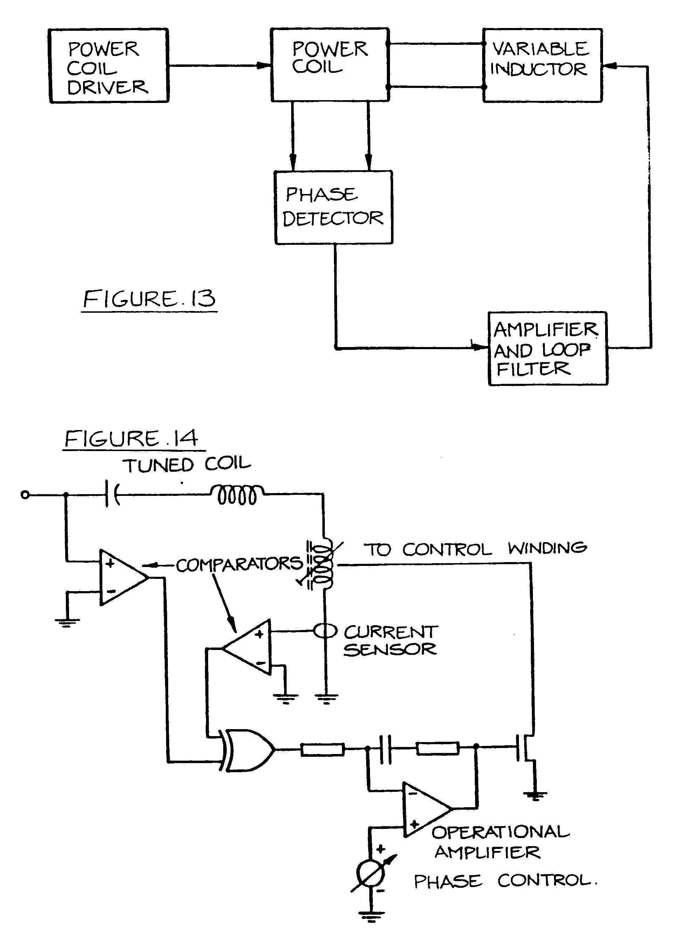

A small value resistance or current transformer coupled in series with the tuned circuit can sense the phase of the coil's current. A phase detector can compare the current's phase and the input signal's phase, the output of which can be filtered and provide a dc control current for use by the variable inductance. This system is not a phase locked loop, rather it is a phase feedback loop. Figure 13 shows a schematic of this type of system and an example circuit implementation thereof is shown in Figure 14.

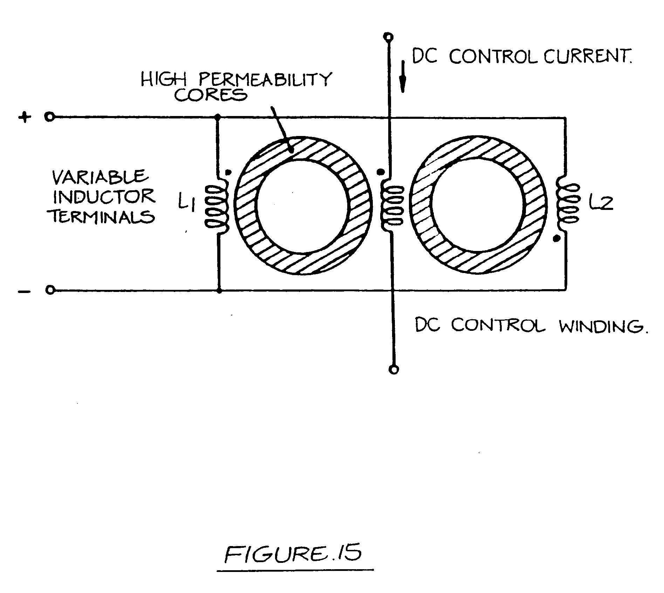

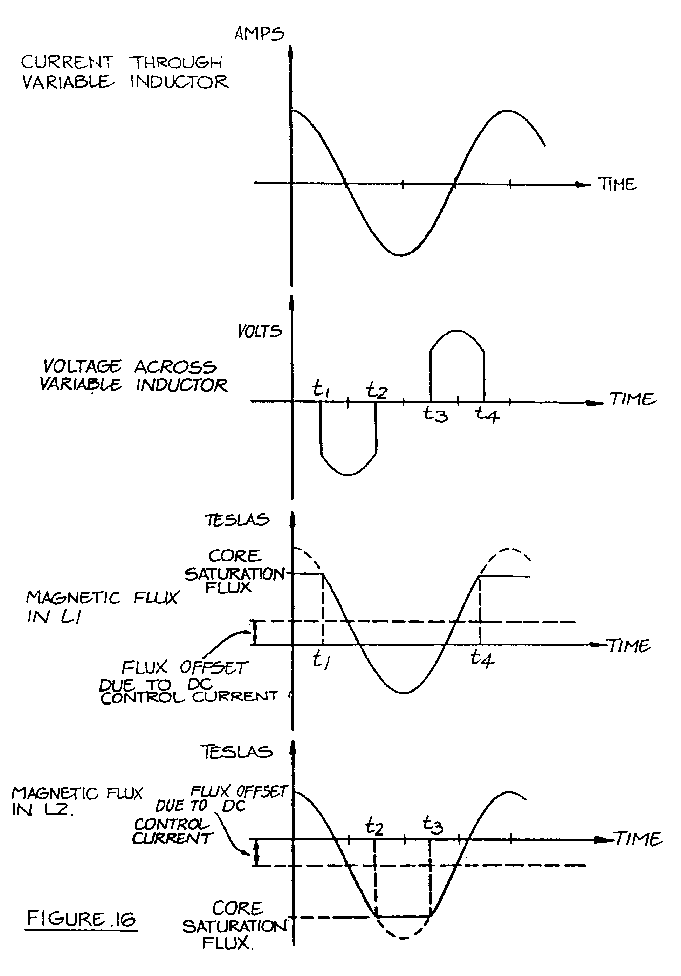

The variable inductance may preferably be made from two anti-parallel magnetically isolated coils. Figure 15 shows this in stylised form. Two high permeability cores act as magnetic paths for the flux generated by coils L1 and L2. These coils are wound so that their fluxs are oppositely directed through the control winding Lc. L1 and L2 have the same number of turns. Since they are wired in parallel, they both have equal voltages across them, therefore, the rate of change of flux in their respective toroid cores is substantially identical. Consequently, the total flux change in the control winding is substantially zero and little, if any, voltage is induced into the control winding, even when substantial currents flow through L1 and L2. Passing a dc current through the control winding pre-biases the cores with oppositely directed fluxes. During one half of the ac cycle, the dc flux opposes the ac flux in one core while it aids it in the other core. During the second half of the cycle, the ac flux reverses direction and aids the dc flux in the first core while opposing it in the second core. This repeats for each cycle. If the flux in the core with aiding flux exceeds the saturation level, then the dynamic permeability becomes very small and the inductance of the coil wound on to the core is reduced. The inductance of the system is substantially the parallel inductance of L1 and L2. Hence, the inductance becomes very small. While the inductance may not be constant over a cycle, the modification of the coil's resonant frequency depends upon the average inductance per cycle of the variable inductor. Various waveforms for the variable inductor are shown in Figure 16. When either L1 or L2 saturates, their inductance becomes very small and the voltage across them becomes almost zero. Inductance is defined by the voltage induced for a rate of change in current. Extracting the fundamental component of voltage across the inductor for a fixed sinusoidal current will give the effective inductance. The effect of higher harmonic terms is attenuated by the filtering action of the tuned coils. As the dc control current is increased, the effective inductance is reduced from a maximum unsaturated core value to that of parallel air cored inductors.

The preferred arrangement works well in the series connected case as shown in Figure 11. In this configuration, a small inductance with a large control range may provide adequate control of the tuned coil pair resonant frequency. Adequate control, of course, is dependant upon the overall system's particular application.

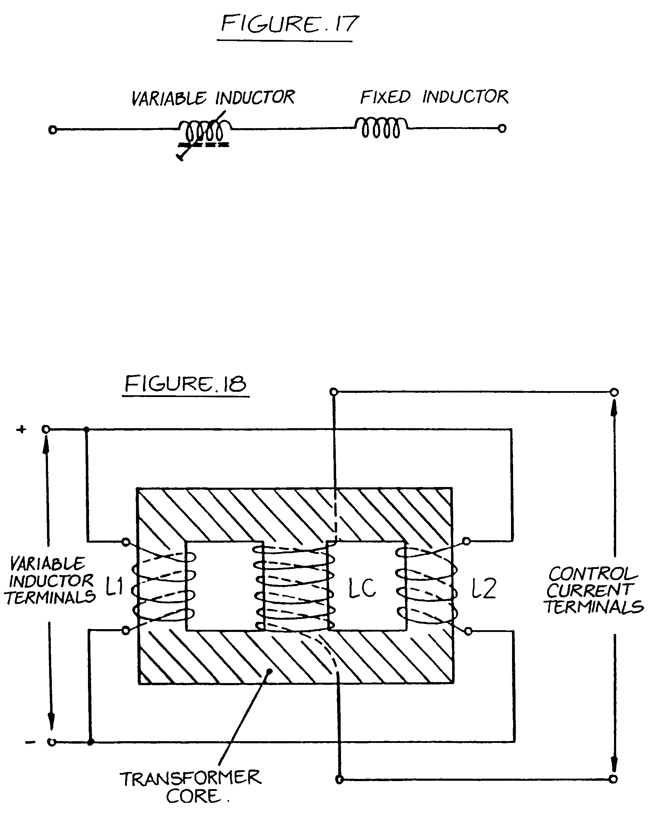

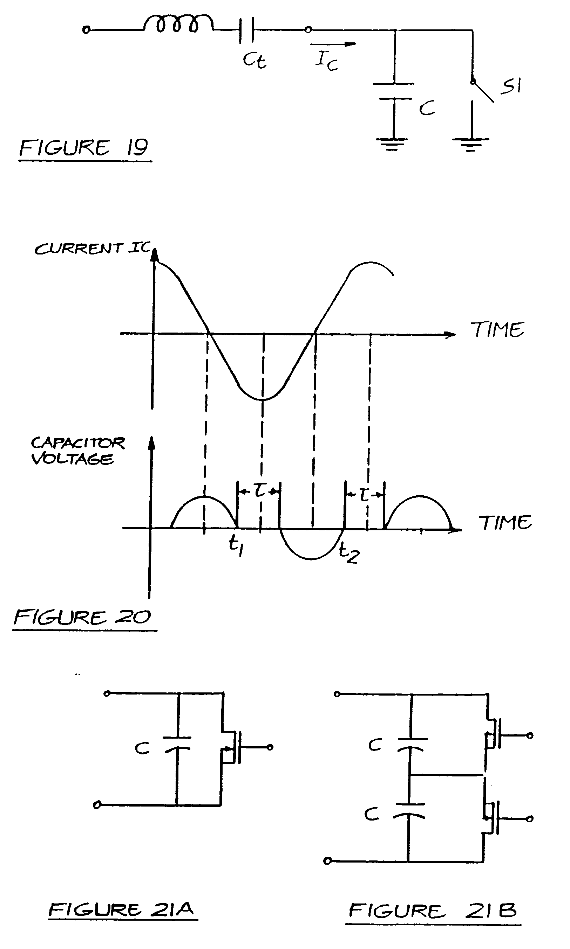

The parallel case as shown in Figure 12 may require a large parallel inductance with a small control range to adequately control the resonant frequency. This may be achieved by placing a large fixed inductance in series with a smaller variable inductance, as shown in Figure 17. A standard transformer core can also be used to construct a variable inductance, as shown in Figure 18. The rate of change of flux through the centre leg from L1 and L2 is constrained to substantially zero by the anti-parallel connection of L1 and L2. Consequently, relatively no ac voltage is coupled into the control winding Lc.

If ac voltage couples into the centre leg because of uneven winding of L1 and L2, then an inductance in series with the control winding will alleviate any upset in the control dc circuitry from this ac voltage.

Figure 19 shows a variable capacitor used to control the coil pair resonant frequency. The capacitance is varied by controlling the duty cycle of the switch closure S1.

With reference to Figure 20, when the voltage across capacitor C in Figure 19 is zero (t₁) switch S1 closes and stays closed for period I where upon it opens. The capacitor C is charged for the remainder of the cycle by the coil current. When the capacitor voltage is next zero (t₂) the switch again recloses for I. The cycle is then repeated. The effective capacitance of the switch capacitor combination varies from the full capacitance C when the switch is always open to infinite capacitance when the switch is always closed.

Figure 21 shows some practical embodiments of the variable capacitor. The dc voltage across C varies with the switching duty cycle in the circuit shown in Figure 21A. The circuit shown in Figure 21B does not suffer from this.

## Claims

1. Apparatus for powering a transponder at a substantially uniform level of power substantially irrespective of the transponder's orientation and within a volume of space having width, height and depth directions, said apparatus comprising:
first, second and third powering coils each for radiating a respective powering field for reception by the transponder in one of the width, height and depth directions in said volume of space; and excitation means for applying current to each coil in a predetermined manner, characterized in that:
(a) said means for applying current excites sinusoidally any two of the coils at any one time by providing a single frequency sine signal to one of the coils and a single frequency cosine signal to another of the coils whilst the unexcited coil is left idle;
the excitation is provided in a sequential and periodic manner in that the excitation is removed from the coil winding excited for the longest time and is applied to the previously unexcited coil; and
each signal exciting the coils is unmodulated; or
(b) said means for applying current sinusoidally excites three of the coils, one coil with a first sine signal at a first frequency, the other coil with a substantially in-phase second sine signal at the first frequency and the third coil with a third, cosine signal at the first frequency; and
the first and second sine signals are double-side band modulated at a low frequency with a phase-shifted angle of substantially 90°; or
(c) said means for applying current excites sinusoidally three of the coils, one coil with a single frequency sine signal, another coil with a single frequency cosine signal and the third coil with a signal marginally different in frequency from the single frequency sine and cosine signal; and
each signal exciting the coils is unmodulated; or
(d) said means for applying current excites sinusoidally three of the coils, one coil with a single frequency first signal, another coil with a single frequency second signal and the third coil with a third signal, the signals differing from each other marginally in frequency; and
each signal exciting coils is unmodulated.

2. Apparatus as claimed in Claim 1, wherein one of the powering coils is a solenoid coil.

3. Apparatus as claimed in Claim 1 or 2, wherein each coil is formed of a pair of windings of predetermined configuration, the winding pair being positioned adjacent each other in opposite and facing configuration.

4. Apparatus as claimed in Claim 3, wherein each winding pair includes a separation distance in the range from 0.1 to two times a length (d) of one of the winding sides.

5. Apparatus as claimed in Claim 4, wherein the separation distance is substantially 0.8d.

6. Apparatus as claimed in any of Claims 3, 4 and 5, wherein the predetermined configuration is square or rectangular or elliptical or circular or C-shaped.

7. Apparatus as claimed in any of Claims 3 to 6, wherein the windings of each pair of windings are arranged in substantially parallel planes.

8. Apparatus as claimed in any of Claims 3 to 7, further comprising a mutual coupling element in the form of an inductance in series with at least one of said coils for substantially reducing mutual coupling between coils for different directional fields, each inductance being mutually coupled into the magnetic field of at least one other coil.

9. Apparatus as claimed in any of Claims 2 to 8, further comprising a receiving unit having a pickup coil and being positioned within the substantially uniform magnetic field.

10. Apparatus as claimed in Claim 9, wherein at least a portion of said pickup coil is enclosed in a Faraday shield.

11. Apparatus as claimed in Claim 9 or 10, further comprising coil element(s), the or each element being provided in series with a respective receiving coil, the coil element being adapted to reduce the mutual coupling between the receiving coils and the series element and at least one of said coils providing said powering field.

12. Apparatus as claimed in Claim 9 or 10, further comprising interference element(s), the or each element being provided in series with a respective coil, the interference element being a further coil adapted to obviate interference signals radiating from sources external to said structure.

13. A method of powering a transponder within a volume of space having width, height and depth directions the method providing a substantially uniform level of power to the transponder substantially irrespective of the transponder's orientation and position within the volume of space, the method comprising providing current to each of first, second and third power coils in the width, height and depth directions respectively in the volume of space, the method being characterized by providing:
(a) a single frequency sine signal to one of the coils and a single frequency cosine to another of the coils, and leaving the third coil unexcited, the signal applied to a coil for the longest time being removed and applied to the previously unexcited coil, the signals being unmodulated and provided in a sequential and periodic manner; or
(b) applying signals all having the same frequency to the three coils, one coil with a first sine signal, another coil with a substantially in-phase second sine signal and the third coil with a cosine signal, the first and second sine signals being double-side band modulated at a low frequency with a phase shifted angle of substantially 90°; or
(c) applying to the coils unmodulated signals, one coil with a single frequency sine signal, another coil with a single frequency cosine signal, and the third coil with a signal marginally different in frequency from the sine and cosine signals; or
(d) applying to the coils unmodulated signals, one coil with a single frequency first signal, another coil with a single frequency second signal, and the third coil with a third signal, the signals differing from each other marginally in frequency.

## Patentansprüche

1. Vorrichtung zum Aktivieren eines Senders auf ein im wesentlichen gleichförmiges Leistungsniveau, im wesentlichen unabhängig von der Orientierung des Senders und innerhalb eines Raumvolumens mit einer Breitenrichtung, einer Höhenrichtung und einer Tiefenrichtung, wobei die Vorrichtung folgendes umfaßt:
erste, zweite und dritte Aktivierungsspulen jeweils zum Ausstrahlen eines entsprechenden Aktivierungsfeldes zum Empfangen durch den Sender in der Breitenrichtung, Höhenrichtung oder Tiefenrichtung in besagtem Raumvolumen; und
Anregungsmittel zum Anlegen eines Stroms an jede Spule in einer vorherbestimmten Art, dadurch gekennzeichnet, daß:
(a) das Mittel zum Anlegen des Stroms sinusförmig irgendwelche zwei der Spulen zu irgendeinem Zeitpunkt durch Liefern eines Sinussignals mit einer einzigen Frequenz zu einer der Spulen und eines Kosinussignals mit einer einzigen Frequenz zu einer anderen der Spulen anregt, während die nicht angeregte Spule untätig bleibt;
die Anregung in einer aufeinanderfolgenden und periodischen Weise geliefert wird, so daß die Anregung von der Spulenwicklung, die für die längste Zeitdauer angeregt ist, entfernt und auf die zuvor nicht angeregte Spule angelegt wird; und
jedes die Spulen anregende Signal unmoduliert ist; oder
(b) das Mittel zum Anlegen des Stroms sinusförmig drei der Spulen anregt, eine Spule mit einem ersten Sinussignal bei einer ersten Frequenz, die andere Spule mit einem im wesentlichen gleichphasigen zweiten Sinussignal an der ersten Frequenz und die dritte Spule mit einem dritten Kosinussignal an der ersten Frequenz; und
das erste Sinussignal und das zweite Sinussignal mit einer niedrigen Frequenz und einem phasenverschobenen Winkel von im wesentlichen 90° zwei-seitenbändig moduliert sind; oder
(c) das Mittel zum Anlegen des Stroms sinusförmig drei der Spulen anregt, eine Spule mit einem Sinussignal mit einer einzigen Frequenz, eine andere Spule mit einem Kosinussignal mit einer einzigen Frequenz und die dritte Spule mit einem Signal, das sich nur marginal in der Frequenz von der einzigen Frequenz des Sinus- und Kosinussignals unterscheidet; und
jedes die Spulen anregende Signal unmoduliert ist; oder
(d) das Mittel zum Anlegen des Stroms drei der Spulen sinusförmig anregt, eine Spule mit einem ersten Signal mit einer einzigen Frequenz, eine andere Spule mit einem zweiten Signal mit einer einzigen Frequenz und die dritte Spule mit einem dritten Signal, wobei sich die Signale jeweils nur marginal in ihrer Frequenz voneinander unterscheiden; und
jedes die Spulen anregende Signal unmoduliert ist.

2. Vorrichtung nach Anspruch 1, dadurch gekennzeichnet, daß eine der Aktivierungsspulen eine Solenoid-Spule ist.

3. Vorrichtung nach Anspruch 1 oder 2, dadurch gekennzeichnet, daß jede Spule aus einem Paar von Wicklungen einer vorherbestimmten Konfiguration gebildet ist, wobei das Wicklungspaar benachbart zueinander in einer umgekehrten und sich gegenüberstehenden Anordnung positioniert ist.

4. Vorrichtung nach Anspruch 3, dadurch gekennzeichnet, daß jedes Wicklungspaar einen Trennungsabstand in dem Bereich von 0 bis zweimal eine Länge (d) einer der Wicklungsseiten enthält.

5. Vorrichtung nach Anspruch 4, dadurch gekennzeichnet, daß der Trennungsabstand im wesentlichen 0,8 d beträgt.

6. Vorrichtung nach irgendeinem der Ansprüche 3, 4 und 5, dadurch gekennzeichnet, daß die vorherbestimmte Anordnung quadratisch oder rechteckig oder ellipsoid oder kreisförmig oder C-förmig ist.

7. Vorrichtung nach irgendeinem der Ansprüche 3 bis 6, dadurch gekennzeichnet, daß die Wicklungen jedes Wicklungspaars in im wesentlichen parallelen Ebenen angeordnet sind.

8. Vorrichtung nach irgendeinem der Ansprüche 3 bis 7, gekennzeichnet durch ein transformatorisches Kopplungselement in der Form einer Induktionsspule in Reihe mit zumindest einer der Spulen zum erheblichen Reduzieren der gegenseitigen Kopplung zwischen den Spulen für unterschiedliche Feldrichtungen, wobei alle Induktionsspulen gegenseitig gekoppelt sind, jeweils über das Magnetfeld zumindest einer anderen Spule.

9. Vorrichtung nach irgendeinem der Ansprüche 2 bis 8, gekennzeichnet durch eine Empfangseinheit, die eine Pickup-Spule aufweist und innerhalb des im wesentlichen gleichförmigen Magnetfeldes angeordnet ist.

10. Vorrichtung nach Anspruch 9, dadurch gekennzeichnet, daß zumindest ein Bereich der Pickup-Spule von einer Faraday-Abschirmung umschlossen ist.

11. Vorrichtung nach Anspruch 9 oder 10, gekennzeichnet durch ein Spulenelement oder Spulenelemente, wobei das oder jedes Element in Reihe mit einer entsprechenden Empfangsspule bereitgestellt ist, das Spulenelement zum Reduzieren der gegenseitigen Kopplung der Empfangsspulen und der Reihenelemente geeignet ist und zumindest eine der Spulen das Aktivierungsfeld liefert.

12. Vorrichtung nach Anspruch 9 oder 10, gekennzeichnet durch ein Interferenzelement oder Interferenzelemente, wobei das oder jedes Element in Reihe mit einer entsprechenden Spule bereitgestellt ist und das Interferenzelement eine weitere Spule ist, die zum Verhindern der Abstrahlung von Interferenzsignalen von Quellen außerhalb des Aufbaus geeignet ist.

13. Verfahren zum Aktivieren eines Senders innerhalb eines Raumvolumens mit einer Breiten-, einer Höhen- und einer Tiefenrichtung, wobei das Verfahren ein im wesentlichen gleichförmiges Leistungsniveau an den Sender liefert, im wesentlichen unabhängig von der Orientierung des Senders und der Position innerhalb des Raumvolumens, das Verfahren das Liefern von Strom an jede der ersten, zweiten und dritten Aktivierungsspulen in der Breiten-, Höhen- bzw. Tiefenrichtung in dem Raumvolumen umfaßt und gekennzeichnet ist durch:
(a) Liefern eines Sinussignals mit einer einzigen Frequenz an eine der Spulen und eines Kosinussignals mit einer einzigen Frequenz an eine andere der Spulen und Unangeregtlassen der dritten Spule, wobei das für die längste Zeitdauer an eine Spule angelegte Signal entfernt und an eine zuvor nicht angeregte Spule angelegt wird und die Signale unmoduliert sind sowie in einer aufeinanderfolgenden und periodischen Weise bereitgestellt werden; oder
(b) Anlegen von Signalen, die alle die gleiche Frequenz haben, an die drei Spulen, ein erstes Sinussignal an eine Spule, ein im wesentlichen gleichphasiges zweites Sinussignal an eine andere Spule und ein Kosinussignal an die dritte Spule, wobei das erste und das zweite Sinussignal mit einer niedrigen Frequenz und einem phasenverschobenen Winkel von im wesentlichen 90° zwei-seitenbändig moduliert werden; oder
(c) Anlegen von unmodulierten Signalen an die Spulen, ein Sinussignal mit einer einzigen Frequenz an eine Spule, ein Kosinussignal mit einer einzigen Frequenz an eine andere Spule und ein Signal, das sich nur marginal in der Frequenz von dem Sinus- und Kosinussignal unterscheidet, an die dritte Spule; oder
(d) Anlegen von unmodulierten Signalen an die Spulen, ein erstes Signal mit einer einzigen Frequenz an eine Spule, ein zweites Signal mit einer einzigen Frequenz an eine andere Spule und ein drittes Signal an die dritte Spule, wobei sich die Signale jeweils voneinander marginal in der Frequenz unterscheiden.

## Revendications

1. Dispositif d'alimentation d'un répondeur d'identification à un niveau sensiblement uniforme de puissance, pratiquement indépendamment de l'orientation du répondeur d'identification et dans un volume d'espace ayant des directions de largeur, de hauteur et de profondeur, ledit dispositif comprenant :
des première, deuxième et troisième bobines d'alimentation, servant chacune à irradier un champ d'alimentation respectif de réception par le répondeur d'identification dans l'une des directions de largeur, hauteur et profondeur dans ledit volume d'espace; et un moyen d'excitation servant à appliquer du courant à chaque bobine d'une manière prédéterminée, caractérisé en ce que :
a) ledit moyen servant à appliquer du courant excite de manière sinusoïdale deux bobines quelconques parmi les bobines, à un moment quelconque, en fournissant un signal sinusoïdal à fréquence unique à l'une des bobines et un signal cosinusoïdal à fréquence unique, à une autre bobine tandis que la bobine non excitée est laissée au repos;
l'excitation est fournie de manière séquentielle et périodique, par le fait que l'excitation est éliminée de l'enroulement de bobine excité pendant la plus longue période et est appliquée à la bobine non excitée au préalable; et
chaque signal excitant les bobines n'est pas modulé; ou
b) ledit moyen servant à appliquer du courant de manière sinusoïdale excite trois des bobines, une bobine avec un premier signal sinusoïdal à une première fréquence, l'autre bobine avec un deuxième signal sinusoïdal sensiblement en phase à la première fréquence et la troisième bobine avec un troisième signal cosinusoïdal à la première fréquence; et
les premier et deuxième signaux sinusoïdaux sont modulés à deux bandes latérales à une faible fréquence, avec un angle de déphasage sensiblement égal à 90°; ou
c) ledit moyen servant à appliquer un courant excite de manière sinusoïdale trois des bobines, une bobine avec un signal sinusoïdal à fréquence unique, une autre bobine avec un signal cosinusoïdal à fréquence unique et la troisième bobine avec un signal différent de façon marginale en ce qui concerne sa fréquence par rapport aux signaux sinusoïdal et cosinusoïdal à fréquence unique; et
chaque signal excitant les bobines n'est pas modulé; ou
d) ledit moyen d'application de courant excite de manière sinusoïdale trois des bobines, une bobine avec un premier signal à fréquence unique, une autre bobine avec un deuxième signal à fréquence unique et la troisième bobine avec un troisième signal, les signaux étant différents entre eux de manière marginale en ce qui concerne leur fréquence; et
chaque signal excitant les bobines n'est pas modulé.

2. Dispositif selon la revendication 1, dans lequel l'une des bobines d'alimentation est une bobine de solénoïde.

3. Dispositif selon la revendication 1 ou 2, dans lequel chaque bobine est constituée d'un couple d'enroulements ayant une configuration prédéterminée, les deux enroulements étant disposés de manière adjacente l'un à l'autre, selon une configuration opposée et se faisant face.

4. Dispositif selon la revendication 3, dans lequel chaque couple d'enroulements comprend une distance de séparation comprise dans la plage allant de 0 à deux fois la longueur (d) de l'un des côtés d'enroulement.

5. Dispositif selon la revendication 4, dans lequel la distance de séparation est sensiblement 0,8 d.

6. Dispositif selon l'une quelconque des revendications 3, 4 et 5, dans lequel la configuration prédéterminée a une forme carrée, rectangulaire, elliptique, circulaire ou en C.

7. Dispositif selon l'une quelconque des revendications 3 à 6, dans lequel les enroulements de chaque couple d'enroulements sont disposés dans des plans sensiblement parallèles.

8. Dispositif selon l'une quelconque des revendications 3 à 7, comprenant en outre un élément de couplage mutuel se présentant sous la forme d'une inductance en série avec au moins l'une desdites bobines, pour réduire sensiblement le couplage mutuel entre les bobines pour différents champs directionnels, chaque inductance étant couplée mutuellement dans le champ magnétique d'au moins une autre bobine.

9. Dispositif selon l'une quelconque des revendications 2 à 8, comprenant en outre un ensemble de réception comportant une bobine exploratrice et étant disposé dans le champ magnétique sensiblement uniforme.

10. Dispositif selon la revendication 9, dans lequel au moins une partie de ladite bobine exploratrice est renfermée dans une cage de Faraday.

11. Dispositif selon la revendication 9 ou 10, comprenant en outre un ou plusieurs éléments de bobine, le ou chaque élément étant prévu en série avec une bobine de réception respective, l'élément de bobine étant adapté pour réduire le couplage mutuel entre les bobines de réception et l'élément en série et au moins l'une desdites bobines fournissant ledit champ d'alimentation.

12. Dispositif selon la revendication 9 ou 10, comprenant en outre un ou plusieurs éléments d'interférence, le ou chaque élément d'interférence étant prévu en série avec une bobine respective, l'élément d'interférence étant une autre bobine adaptée pour supprimer des signaux d'interférence rayonnés par des sources extérieures à ladite structure.

13. Procédé d'alimentation d'un répondeur d'identification dans un volume d'espace ayant des directions de largeur, hauteur et profondeur, le procédé fournissant un niveau sensiblement uniforme de puissance au répondeur d'identification, pratiquement indépendamment de l'orientation et de la position du répondeur d'identification dans le volume d'espace, le procédé comprenant l'amenée d'un courant à chacune des première, deuxième et troisième bobines d'alimentation, respectivement dans les directions de largeur, hauteur et profondeur dans le volume d'espace, le procédé étant caractérisé par :
a) l'amenée d'un signal sinusoïdal à fréquence unique à l'une des bobines et d'un signal cosinusoïdal à fréquence unique à une autre des bobines, et la non excitation de la troisième bobine, le signal appliqué à une bobine pendant la plus longue période étant éliminé et appliqué à la bobine non excitée au préalable, les signaux n'étant pas modulés et étant fournis de manière séquentielle et périodique; ou
b) l'application de signaux ayant tous la même fréquence aux trois bobines, une bobine avec un premier signal sinusoïdal, une autre bobine avec un deuxième signal sinusoïdal sensiblement en phase et la troisième bobine avec un signal cosinusoïdal, les premier et deuxième signaux sinusoïdaux étant modulés à deux bandes latérales à faible fréquence, avec un angle de déphasage sensiblement égal à 90°; ou
c) l'application aux bobines de signaux non modulés, une bobine avec un signal sinusoïdal à fréquence unique, une autre bobine avec un signal cosinusoïdal à fréquence unique et la troisième bobine avec un signal marginalement différent en ce qui concerne sa fréquence par rapport aux signaux sinusoïdal et cosinusoïdal; ou
d) l'application aux bobines de signaux non modulés, une bobine avec un premier signal à fréquence unique, une autre bobine avec un deuxième signal à fréquence unique et la troisième bobine avec un troisième signal, les signaux étant différents entre eux de façon marginale en ce qui concerne leur fréquence.
